# EUROPEAN PATENT SPECIFICATION

(11) **EP 2 225 612 B1**
(45) Date of publication and mention of the grant of the patent: **16.11.2016**
(21) Application number: 08864273.1
(22) Date of filing: 17.12.2008
(51) Int. Cl.: G03F 7/09, G03F 7/032, B41N 3/00, G03F 7/031, G03F 7/32, G03F 7/16

(54) **A METHOD FOR PREPARING LITHOGRAPHIC PRINTING PLATE PRECURSORS**
VERFAHREN ZUR HERSTELLUNG VON VORLÄUFERN LITHOGRAPHISCHER DRUCKPLATTEN
PROCÉDÉ POUR PRÉPARER DES PRÉCURSEURS DE PLAQUE D'IMPRESSION LITHOGRAPHIQUE

(30) Priority: 19.12.2007 EP 07123565; 20.12.2007 US 8348
(43) Date of publication of application: 08.09.2010
(73) Proprietor: Agfa Graphics N.V., 2640 Mortsel (BE)
(72) Inventor: VERSCHUEREN, Veerle, 2640 Mortsel (BE); HENDRIKX, Peter, 2640 Mortsel (BE); GRIES, Willi-Kurt, 2640 Mortsel (BE); VAN DAMME, Marc, 2640 Mortsel (BE)
(74) Representative: Goedeweeck, Rudi
(86) International application number: PCT/EP2008/067713
(87) International publication number: WO 2009/080645

(56) References cited:
- EP-A- 1 288 720
- EP-A- 1 349 006
- EP-A- 1 591 242
- EP-A- 1 688 792
- EP-A- 1 722 274
- WO-A-2006/048445
- WO-A-2008/145530
- US-A1- 2005 158 663
- US-A1- 2006 194 154

## Description

### FIELD OF THE INVENTION

The invention relates to a method of making a violet light sensitive photopolymer printing plate precursor.

### BACKGROUND OF THE INVENTION

In lithographic printing, a so-called printing master such as a printing plate is mounted on a cylinder of the printing press. The master carries a lithographic image on its surface and a printed copy is obtained by applying ink to said image and then transferring the ink from the master onto a receiver material, which is typically paper. In conventional, so-called 'wet' lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. In so-called 'driographic' printing, the lithographic image consists of ink-accepting and ink-abhesive (ink-repelling) areas and during driographic printing, only ink is supplied to the master.
Printing masters are generally obtained by the so-called computer-to-film (CtF) method wherein various pre-press steps such as typeface selection, scanning, color separation, screening, trapping, layout and imposition are accomplished digitally and each color selection is transferred to graphic arts film using an image-setter. After processing, the film can be used as a mask for the exposure of an imaging material called plate precursor and after plate processing, a printing plate is obtained which can be used as a master. Since about 1995, the so-called 'computer-to-plate' (CtP) method has gained a lot of interest. This method, also called 'direct-to-plate', bypasses the creation of film because the digital document is transferred directly to a plate precursor by means of a so-called plate-setter. A plate precursor for CtP is often called a digital plate.

Digital plates can roughly be divided in three categories : (i) silver plates, which work according to the silver salt diffusion transfer mechanism; (ii) photopolymer plates which contain a photopolymerizable composition that hardens upon exposure to light and (iii) thermal plates of which the imaging mechanism is triggered by heat or by light-to-heat conversion. Thermal plates are mainly sensitized for infrared lasers emitting at 830 nm or 1064 nm. Typical photopolymer plates are sensitized for visible light, mainly for exposure by an Ar laser (488 nm) or a FD-YAG laser (532 nm).

The wide-scale availability of low cost blue or violet laser diodes, originally developed for data storage by means of DVD, has enabled the production of plate-setters operating at shorter wavelength. More specifically, semiconductor lasers emitting from 350 to 450 nm have been realized using an InGaN material. An advantage of violet plate-setters, compared to visible light plate-setters, are the improved safe-light conditions. Laser diodes, emitting violet light with a wavelength around 405 nm (± 15 nm) are at present the most important, commercially available, violet laser diodes. Photopolymer plates generally contain a polymerizable monomer, a binder, a photo-initiator and a sensitizing dye. EP-A 985 683, EP-A 1 048 982 and EP-A 1 070 990 disclose a composition comprising a titanocene compound as photo-initiator and specific dyes as sensitizers for the wavelength range from 350 to 450 nm. EP-A 1 035 435 discloses a 1,3-dihydro-1-oxo-2H-indene derivative as sensitizing dye. A wide range of dyes for the wavelength range from 300 to 1200 nm is disclosed in EP-A 1 091 247.
To enable short exposure times with the commercially available blue or violet laser diodes, resulting in a higher throughput (i.e. higher numbers of printing plate precursors that can be exposed in a given time interval) there is a need to increase the sensitivity of violet light sensitive photopolymerizable compositions. EP-A 1 349 006 and WO2005/029187 disclose a photopolymerizable composition using optical brightheners, e.g. distyrylbenzenes, as sensitizers, suitable for exposure with violet laser diodes. In EP-A 1 621 928, a composition is disclosed which is photopolymerizable upon absorption of light in the wavelength range from 300 to 450 nm, the composition comprising a binder, a polymerizable compound, a sensitizer and a photo-initiator, wherein the sensitizer is a fluorene compound conjugated via a double or triple bond with an aromatic or heteroaromatic group. Also in EP-A 1 591 242 and 1 688 792, distyryl benzenes are disclosed as efficient sensitizers for the wavelength range of from 300 to 450 nm.

The photopolymerizable compositions described in EP-A 1 349 006, WO2005/029187 and EP-A 1 621 928 are high enough in sensitivity to enable exposure with violet light having an energy density, measured on the surface of the plate, of 100 µJ/cm² or less.

It is well known in the art that a grained and anodized aluminum is preferably subjected to a so-called post-anodic treatment, also referred to as PAT, to optimize the properties of the anodized aluminum surface. Such a PAT may be realized by immersion of the anodized aluminum surface in a particular solution or by coating a hydrophilic layer between the anodized aluminum surface and the photopolymerizable layer. Violet light sensitive photopolymer plate precursors specifically disclosed in the prior art all use a grained and anodized aluminum support which has been subjected to such treatments.

EP-A 1 564 589 discloses an alkali-processable violet light sensitive photopolymer printing plate precursor comprizing a photo-polymerizable layer characterized by a total monomer to total binder polymer ratio of less than 1.5, most preferably of from 0.1 to 0.8.

Development of the according printing plate precursor, respectively with and without a brush, results in a small rendering difference of the one-pixel lines on the printing plate. All printing plate precursors disclosed comprise a grained and anodized aluminum support which has been subjected to a post-anodic treatment, or comprise an undercoat layer present between the anodized aluminum support and the photo-polymerizable layer.

EP-A 1 591 242 discloses a photopolymer printing plate precursor comprising a fluorescent brightening agent, a photo-initiator, a polymerizable compound and a polyurethane binder. All examples either comprise a back coating or are subjected to a hydrophilizing treatment.

EP-A 1 288 720 discloses a photopolymer printing plate precursor comprising a crosslinking agent having two ethylenic polymerizable groups and a crosslinking agent having three or more ethylenic polymerizable groups. All examples comprise a back coating.

US2005/0158663 discloses a method of printing wherein a used printing plate is reused.

EP-A 1 614 537 discloses an on-press processable violet light sensitive photopolymer printing plate precursor, comprizing a photo-polymerizable layer characterized by a total monomer to total binder ratio of between 0.5 and 3.5, more preferably between 0.8 and 3.5. All printing plate precursors disclosed comprise a grained and anodized aluminum support which has been subjected to a post-anodic treatment, or comprise an undercoat layer present between the aluminum support and the photopolymerizable layer.

One of the limitations of photopolymer digital plate technology is the resolution on the printed sheet. To ascertain a sufficient curing level, especially in the fine image details, to withstand the mechanical and physical strains on a printing press, the photopolymer printing plate precursors are very often overexposed. However, such overexposure results often in a substantial dot gain on the plate after imaging and development. As a result, the rendering of images on the plate has been limited to those according to screen rulings typically lower than 150 lines per inch (lpi) or 60 1/cm. This limitation makes the photopolymer plate technology often unusable for commercial printing applications. For these reasons, photopolymer printing plates have their prime application in the newspaper printing industry, where the demanding press conditions have contributed to a practice of overexposure and high dot gain.

For commercial printing applications, a higher resolution on the printed sheet is required. Additionally, the image rendering has to be stable during the press run to prevent colour shifts or variations. It has been observed for violet light sensitive photopolymer plates that during the press run, especially in the fine image details, substantial dot loss may occur during the first 10 000 impressions.

### SUMMARY OF THE INVENTION

The first object of the present invention is to provide a method of preparing photopolymer printing plate precursors enabling the production of printing plates characterized by a minimal dot loss during printing and a high run length.
A second object of the present invention is to provide a method of preparing such printing plates.

The first object of the invention is realized by the method as defined in claim 1. It has surprisingly been found that violet light sensitive lithographic printing plate precursors prepared according to the method of the present invention wherein on a grained and anodized aluminum support, without subjecting the anodized aluminum support to a hydrophilizing treatment, also referred to as post-anodic treatment, by applying a hydrophilic layer to the grained and anodized aluminum support, a photopolymerizable layer is coated on the grained and anodized aluminum support to from a polymerizable layer wherein the ratio of the total monomer amount to the total binder amount is from 1.55 to 1.95, results in printing plates having substantially less dot loss during printing, making these violet light sensitive photopolymer printing plate precursors suitable for commercial printing.

Preferred embodiments of the invention are defined in the dependent claims.

### DETAILED DESCRIPTION OF THE INVENTION

The method of preparing a lithographic printing plate precursor according to the present invention comprises the steps of:
- providing an aluminum support;
- graining and anodizing the aluminum support;
- without applying a hydrophilic layer on the anodized aluminum support, coating a composition which is photopolymerizable upon absorption of light having a wavelength in the range of from 350 nm to 450 nm and comprising a polymerizable monomer or oligomer, a binder and a photo-initiator on the grained and anodized aluminum support to form a photopolymerizable layer;
- coating an overcoat on the photopolymerizable layer; characterized in that the ratio of the total solid amount of polymerizable monomer and oligomer to the total solid amount of binder is from 1.55 to 1.95.

### Aluminum support

The support used in the method according to the present invention is an electrochemically grained and anodized aluminum support.

The aluminum support has a thickness of about 0.1-0.6 mm. However, this thickness can be changed appropriately depending on the size of the printing plate used and the platesetter on which the printing plate precursors are exposed.

Graining includes mechanical graining, chemical graining and electrochemical graining in an electrolyte solution containing e.g. nitric acid, sulfuric acid or hydrogen chloride or mixtures thereof. Electrochemical graining in an electrolyte solution containing hydrogen chloride or sulfuric acid, or a mixture thereof is preferred. Electrochemical graining is preferably carried out with a current density between 50 and 400 C/dm², more preferably between 75 and 200 C/dm² at a temperature between 20°C and 100°C, preferably between 25 and 50°C.

The grained aluminum support is then typically desmutted with an acid, such as nitric acid, sulfuric acid, phosphoric acid, chromic acid, hydrofluoric acid of fluorboric acid, or with alkali such as sodium hydroxide or potassium hydroxide.

After rinsing the desmutted support, typically with water, the support is anodized, i.e. Al₂O₃ is formed on the surface of the support. Anodization is carried out by applying a direct or an alternating current, preferably an alternating current, to an aluminum support in an aqueous solution of e.g. sulfuric acid, phosphoric acid, chromic acid, oxalic acid, sulfamic acid, benzenesulfonic acid, or mixtures thereof. Preferably anodization is carried out in an aqueous solution of sulfuric acid. The anodizing conditions depend on the electrolyte solution used, but typically a current density between 0.5 and 60 A/dm², a voltage between 1 and 100 V, a temperature between 5 and 75°C and an electrolysis time between 10 and 100 seconds, are used. Preferred anodic weights are between 0.5 and 10 g/m² of Al₂O₃, more preferably between 1 and 5 g/m² of Al₂O₃.
A preferred aluminum substrate, characterized by an arithmetical mean center-line roughness Ra less then 0.45 µm, is described in EP 1 356 926.

Optimizing the pore diameter and distribution of the micropores of the grained and anodized aluminum surface may enhance the press life of the printing plate and may improve the resolution of the printing plate. Avoiding large and deep pores may also improve the toning behaviour of the printing plate. In EP-A 1 826 001, a method to characterize the surface of a grained and anodized aluminum, is disclosed. The parameter "mean pith depth", calculated according to this characterizing method, correlates with the number and depth of the pits present at the aluminum surface. The "mean pith depth" of the surface of the grained and anodized aluminum support according to the present invention is preferably less then 2.0 µm, more preferably less then 1.8 µm, most preferably less then 1.5 µm. The standard deviation of the "mean pith depth" is preferably less then 0.70 µm, more preferably less then 0.50 µm, most preferably less then 0.35 µm.

The grained and anodized aluminum support may be a sheet-like material such as a plate or it may be a cylindrical element such as a sleeve which can be slid around a print cylinder of a printing press.

An essential aspect of the present invention is the fact that a photopolymerizable composition is coated on the grained and anodized aluminum support to form a polymerizable layer, without applying a hydrophilic layer between the anodized aluminum support and the photopolymerizable layer. The hydrophilic layer referred to encompasses all layers well known in the art containing an inorganic or an organic compound, or a mixture thereof, and applied to an anodized aluminum support to optimize the hydrophilic properties of the anodized aluminum surface and/or the adhesion between the photopolymerizable layer and the anodized support. The hydrophilic layers referred to typically applied by coating a solution containing an inorganic or an organic compounds, or a mixture thereof, on the anodized aluminum support, or by dipping said support into said solution or by spraying said solution onto said support. Such layer are for example described in EP-A 835 764, paragraph [0037] and EP-A 1 564 589, paragraphs [0032] to [0035], EP 1 788 434, paragraph [0007] and include for example:
- a hydrophilic layer obtained by subjecting the anodized aluminum support to an aqueous solution of potassium fluorozirconate or a phosphate;
- a hydrophilic layer obtained by subjected the anodized aluminum support to an aqueous solution of polyvinylphosphonic acid or derivatives thereof or polyacrylic acid;
- a hydrophilic layer obtained by subjecting the anodized aluminum support to an aqueous solution of an alkali metal silicate;

Applying the above described hydrophilic layers to a grained and anodized aluminum support is often referred to as post-anodic treatments.

The hydrophilic layer referred to in the present invention also encompasses a hydrophilic layer referred to as an undercoat layer, a primer layer, an intermediate layer or an adhesion promoting layer as for example described in EP 1 788 434, paragraph [0010] and EP 1 840 653 paragraph [0186] to [0215].

A rinsing step with water and/or a drying step may however be carried out after anodization.

According to the present invention, no hydrophilic layer is applied on either side of the grained and anodized aluminum support. The aluminum support does not comprise a back coating.

### Photopolymerizable layer

In the method according to the present invention, a composition which is polymerizable upon exposure to light having a wavelength of from 350 nm to 450 nm is coated on the grained and anodized aluminum support. The composition comprises a monomer or oligomer, a binder and a photo-initiator. The composition may further comprise other ingredients well known in the art.

### Polymerizable monomer or oligomer

The photopolymerizable layer comprises one or more polymerizable monomer(s) or oligomer(s). Preferred monomer(s) or oligomer(s) are ethylenically unsaturated compounds. These ethylenically unsaturated double bond-containing compounds have at least one, preferably from 2 to 6, terminal ethylenically unsaturated bonds. Preferred monomers include esters of an unsaturated carboxylic acid (e.g. acrylic acid, methacrylic acid, itaconic acid, crotonic acid, isocrotonic acid, and maleic acid) and an aliphatic polyhydric alcohol compound, such as: ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl)ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy) pheny]dimetliylmethane, and bis[p-(methacryloxyethaxy) phenyl]dimethylmethane, ethylene glycol diitaconate, propylene glycol diitaconate, 1,5-butanediol diitaconate, 1,4-butanediol diitaconate, tetramethylene glycol diitaconate, pentaerythritol diitaconate, and sorbitol tetraitaconate, ethylene glycol dicrotonate, tetramethylene glycol dicrotonate, pentaerythritol dicrotonate, sorbitol tetradicrotonate, ethylene glycol diisocrotonate, pentaerythritol diisocrotonate, and sorbitol tetraisocrotonate, ethylene glycol dimaleate, triethylene glycol dimaleate, pentaerythritol dimaleate and sorbitol tetramaleate.

Other preferred monomers include amides of an unsaturated carboxylic acid and an aliphatic polyhydric amine compound, such as: methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Other preferred monomers include urethane compounds containing two or more ethylenically unsaturated bonds. These polymerizable compounds are reaction products of a polyisocyanate compound, containing two or more isocyanate groups, with a multifunctional alcohol of which the hydroxyl groups are partly or completely esterified with (meth)acrylic acid. Particularly preferred compounds are prepared by reacting hydroxyalkyl(meth)acrylates with diisocyanates, as disclosed in DE 28 22 190 and DE 20 64 079.

Other preferred monomers contain primary, secondary and in particular tertiary amino groups, thio or enol groups, as disclosed in EP 1 349 006 (paragraph [0014] to [0024]). An example of a particularly preferred monomer is: 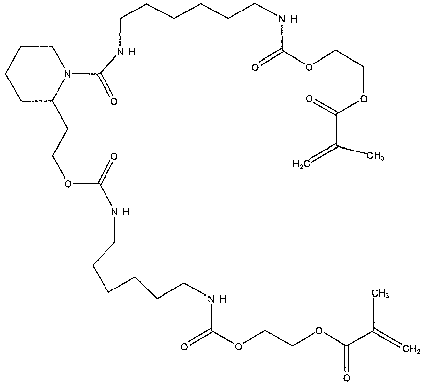 Binder

The photopolymerizable layer also contains a binder. The binder may be selected from a wide series of organic polymers or co-polymers. Also a mixture of two or more different polymers or co-polymers may be used.
The selected binder may be different dependent on the development process of the printing plate precursor, to ensure complete removal of the non-image areas of the photopolymerizable layer during development.

Suitable polymers to be used as binder may include (meth)acrylic resins, polyvinyl acetal resins, polyurethane resins, polyamide resins, epoxy resins, polystyrene resins and polyester resins.

Preferred polymers or co-polymers usable as binder are disclosed in WO2005/111727 (page 17, In.21 to page 20, In.3) and WO2005/029187 (page 16, ln.26 to page 18, ln.11).

The binder is preferably insoluble in water, but soluble or at least swellable in aqueous-alkaline solutions. Preferred binders contain an acid group such as a carboxyl group, a sulfone group or a phosphate group. Particularly preferred and well known are polymers or co-polymers containing carboxyl groups, in particular polymers or co-polymers containing monomeric units of α, β-unsaturated carboxylic acids and/or monomeric units of α, β-unsaturated dicarboxylic acids. Specific examples are polymers or co-polymers of acrylic acid, methacrylic acid, crotonic acid, vinylacetic acid, maleic acid or itaconic acid. Preferred binders have an acid number, expressed as mg KOH/g polymer, of from 10 to 250, preferably from 20 to 200.

In view of improving the developing properties in an aqueous solution, the binder may comprise hydrophilic groups, e.g. a hydroxyl group, a carboxylate group, a hydroxyethyl group, an ethyleneoxy group, an aminopropyl group, an ammonium group, an amido group or a carbomethyl group.

The binder may also comprise a crosslinkable functional group in the main chain or a side chain. A crosslinkable group is capable of crosslinking the polymeric binder upon exposure. The crosslinkable functional group may be an ethylenically unsaturated group, an amino group, an epoxy group, a thiol group, a halogen atom or an onium salt. Preferably, the polymeric binder contains an ethylenically unsaturated group. Examples of suitable crosslinkable binders are discloses in EP 1 748 317 (paragraph [0075] to [0084]). The content of the crosslinkable group (content of radical-polymerizable unsaturated double bond determined by iodine titration) in the binder polymer is preferably from 0.1 to 10.0 mmol, more preferably from 1.0 to 7.0 mmol, and most preferably from 2.0 to 5.5 mmol, per g of binder polymer. The crosslinking property of the binder may increase the durability of the image-areas of the printing plate and therefore improve the run length.

The organic polymers used as binders have a typical mean molecular weight M_{w} between 600 and 200 000, preferably between 1 000 and 100 000.

The total solid amount of binder is preferably less than 42.5 wt.%, more preferably less than 40.0 wt.%, relative to the total weight of the non-volatile components of the polymerizable composition, also referred to as total solid weight of the composition.

The ratio of the total solid amount of polymerizable monomer and oligomer to the total solid amount of binder is from 1.55 to 1.95. The solid amount referred to above means the dry amount monomer, oligomer or binder.

### Sensitizer

In principle, any sensitizer known in the art absorbing light having a wavelength of from 350 to 450 nm may be used in the present invention. Preferably, the sensitizers disclosed in WO2005029187 are used in the present invention.

However, sensitizers may be characterized by a critical crystallization behaviour in the photopolymerizable layer. The formation of crystals may locally decrease the polymerization efficiency resulting in areas in the imaged parts of the precursor partly or completely removed during development. Since these areas may not sufficiently take up ink during printing, a poor, sometimes unacceptable, printing quality may be obtained.

Typical solvents used to prepare a coating solution of the photo-polymerizable layer are organic solvents like 1-methoxy-2-propanol (MOP), methylethylketone (MEK), tetrahydrofurane (THF), etc. Often mixtures of organic solvents are used, e.g. a mixture of MOP and MEK. A typical concentration of sensitizers in the photo-polymerizable layer is between 1.0 and 10 percent by weight, preferably between 2.5 and 7.5 percent by weight, relative to the total weight of the non-volatile ingredients of said image-recording layer. In a coating solution of said photopolymerizable layer, a typical concentration of sensitizers is between 0.1 and 5.0 percent by weight, preferably between 0.25 and 2.5 percent by weight relative to the total weight of the coating solution, including the organic solvents used to prepare the coating solution. Suitable sensitizers are therefore soluble in these organic solvents in the indicated concentration range. For example, WO2005/029187 discloses sensitizers of which the solubility in MEK is above 15 g/kg, measured at 20°C.

However, during the preparation of the printing plate precursor, after providing the photopolymerizable layer onto the support and before providing the optional overcoat onto said photopolymerizable layer, a drying step at elevated temperatures, such as e.g. between 80°C and 100°C, is typically carried out. During this drying step, the organic solvent(s) evaporate(s), resulting in an increase of the concentration of the sensitizers in the photopolymerizable layer. Moreover, if two or more different organic solvents with different boiling points are used, the composition of the solvent mixture may change during the drying step. This increase of the concentration of the sensitizer and/or the change in the composition of the solvent mixture during the drying step may induce crystallization of the sensitizer in the photopolymerizable layer.
Such crystallization of the sensitizer may also occur in deposits of the photopolymerizable layer on guiding rollers of the coating apparatus. Such crystals, present on guiding rollers of the coating apparatus, may induce or enhance nucleation and/or accelerate the crystallization of the sensitizer in the photopolymerizable layer.

The fact that the problems associated with the described crystallization phenomena may only become visible after ageing of the printing plate precursor, may indicate that nuclei are formed in the photopolymerizable layer of a freshly prepared precursor, and that these nuclei may grow and form larger crystals during storage of the precursor. These phenomena may depend on the storage conditions, i.e. temperature and humidity, of the precursor.

The above indicates that crystallization, or the formation of nuclei, may occur during preparation of the precursor, probably during drying of the coated photopolymerizable layer. Drying times are typically between 10 and 80 seconds. Taking into account that especially at the end of the drying step, due to an ever increasing concentration of the sensitizer, the crystallization behaviour becomes more and more critical, the critical time during which crystallization may be induced, may typically be between 10 and 30 seconds.

The crystallization behaviour in a particular solvent at a particular temperature is influenced by the solubility of the sensitizer in that particular solvent at that particular temperature. However, kinetic phenomena may also play an important role, especially when the critical crystallization conditions occur in a limited time frame, as in the drying step described above. If the crystallization kinetics are slow, it may occur that no crystallization will take place, even when the concentration of the sensitizers becomes above the solubility of the sensitizer in the particular solvent, i.e supersaturation occurs.

It has been found that when using a mixture of sensitizers, minimal or no crystallization behaviour of the sensitizers in the photopolymerizable layer is often observed. Preferably, the mixture of sentizers comprises at least two, more preferably at least three different sensitizers.

Preferably, the mixture of sensitizers comprises at least two, more preferably at least three, different sensitizers, according to Formula I, 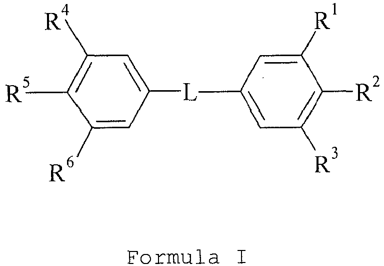 wherein
R¹ to R⁶ independently represent a hydrogen atom, an optionally substituted alkyl group, an optionally substituted alkoxy group, a cyano group, a halogen atom, a dialkylamino group, an alkylarylamino group or a diarylamino group;
L is a divalent linking group selected from the list consisting of:

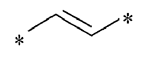

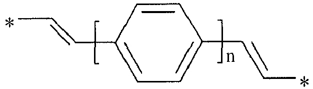

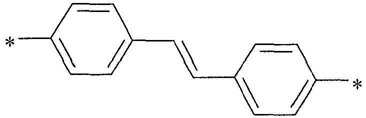

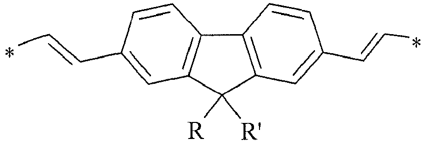

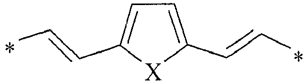

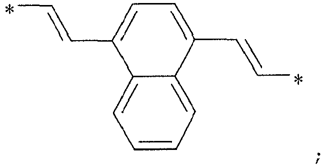

n is an integer from 0 to 2;
X represents S, O or NR^{X};
* represents the linking positions of the linking group L to the phenyl groups of Formula I;
R, R' and R^{X} represent an optionally substituted alkyl group.

More preferably, the mixture comprises sensitizers according to Formula II, 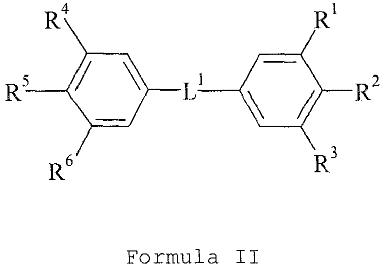 wherein
R¹ to R⁶ have the same meaning as in Formula I;
L¹ is a divalent linking group selected from the list consisting of:

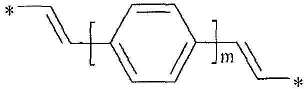

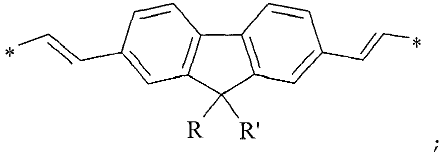

m is 1 or 2, most preferably m is 1.
R and R' have the same meaning as in Formula I;
* represents the linking positions of the linking group L¹ to the phenyl groups of Formula II

The linking groups L and L¹ may comprise one or more substitutents such as e.g. halide atoms, alkoxy groups, carboxylic group, etc.

The alkyl group referred to, also the alkyl group present in the alkoxy groups, means all variants possible for each number of carbon atoms in the alkyl group, i.e. for three carbon atoms: n-propyl and i-propyl; for four carbon atoms: n-butyl, i-butyl, sec-butyl and t-butyl; etc.

The alkyl and alkoxy groups referred to may be substituted for example with a halogen, an ester group, an ether group, a thioether group or a hydroxyl group.

Preferably, R¹ to R⁶ in Formulae I and II are alkoxy group, more preferably R¹, R³, R and R⁶ are methoxy groups and R² and R⁵ are alkoxy groups having 2 to 15 C-atoms, preferably having 3 to 12 C-atoms, most preferably having 4 to 10 C-atoms.

Most preferably, the mixture of sensitizers according to Formula I and II comprises at least one sensitizer wherein R⁵ or R² are branched alkoxy groups having 3 to 15 C-atoms, more preferably having 4 to 10 C-atoms. Particularly preferred, R⁵ or R² are branched alkoxy groups comprising an asymmetric C-atom, e.g. 2-butoxy and 1-(2-ethyl)hexoxy.

An asymmetric C-atom is characterized by four different substituents on the C-atom.

A sensitizer comprising one asymmetric C-atom is characterized by two stereoisomers also referred to as enantiomers. In the present application, a sensitizer comprising one or more asymmetric C-atoms and therefore characterized by two or more stereoisomers, is referred to as one sensitizer. A mixture of sensitizers is defined in the present invention as a mixture of sensitizers each having a different chemical formula.

Sensitizers according to Formula I or II wherein R¹ = R⁴, R² = R⁵ and R³ = R⁶ are referred to as symmetric sensitizers while those according to Formula I or II wherein R¹ ≠ R⁴ or R² ≠ R⁵ or R³ # R⁶ are referred to as asymmetric sensitizers.

Preferably, the mixture comprises at least one asymmetric sensitizer according to Formula I or II. The amount of asymmetric sensitizers in the mixture is preferably at least 25, more preferably at least 35, most preferably at least 45 percent by weight relative to the total amount of sensitizers in the mixture.

According to still another prefered embodiment the mixture of sensitizers is a mixture of sensitizers according to formula II, with the proviso that for at least one sensitizer of said mixture at least one of R¹ to R⁶ contains an asymmetric C-atom and the total amount of sensitizers of which at least one of R¹ to R⁶ contains an asymmetric C-atom is more than 60 percent by weight, preferably more than 70 percent by weight, relative to the total weight of said mixture.

Preferably, the mixture of sensitizers according to Formula I or II comprises less than 25 percent by weight, more preferably less than 10 percent by weight, most preferably no sensitizers according to Formula I or II of which the solubility is less than 7.5 percent by weight in 1-methoxy-2-propanol at 80°C. These low soluble sensitizers according to Formula I or II are often characterized by highly symmetric substituents, e.g. R² = R⁵ = methoxy, 2-propoxy, 3-pentoxy, cyclopentyloxy or cyclohexyloxy.

The mixture of sensitizers comprises at least two, more preferably at least three sensitizers according to Formula I or II. In view of a preferred preparation of the mixture of sensitizers, the mixture preferably comprises 3, 6, 10 or 15, most preferably 3 or 6 different sensitizers.

The mixture of sensitizers may comprise two or more sensitizers according to Formula I or II having the same linking group L or L¹ or may comprise two or more sensitizers having a different linking group L or L¹.

A solution of a mixture of sensitizers according to Formula I and II can be prepared by adding the individual sensitizers of the mixture to the solution or can be prepared in situ as disclosed in the unpublished European patent applications EP-As 07 108 957, 07 108 955 and 07 108 953, all filed on 2007-05-25.

According to another embodiment of the present invention the mixture of sensitizers may also comprise at least two, more preferably at least three different, sensitizers according to Formula III, 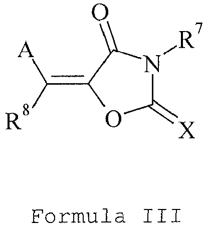 wherein
A represents an aromatic ring which may have a substituent or a heteroring which may have a substituent;
X represents an oxygen atom, a sulfur atom or N-(R⁹);
R⁷, R⁸ and R⁹ independently represent a hydrogen atom or a monovalent non-metallic atomic group;
A and R⁸ and R⁷ and R⁹ may be combined with each other to form an aliphatic or aromatic ring.

Specific examples of sensitizers according to Formula III are disclosed in EP-A 1 748 357 (paragraph [0028] to [0042]) and EP-A 1 048 982 (paragraph [0130] to paragraph [0146]).

As described for the sensitizers according to Formula I and II, the following factors positively influence the preparation of a mixture of sensitizers according to Formula III characterized in that said mixture has in 1-methoxy-2-propanol at 80°C a solubility of at least 30 wt.% and preferably a MetaStable Zone Width (MSZW) of at least 8.5°C measured at a cooling and heating rate of 0.2°C per minute:
- higher number of different sensitizers in the mixture,
- a high solubility of the individual sensitizers,
- asymmetric structure of the sensitizer,
- asymmetric structure of the substituents.

According to still another embodiment of the present invention, the mixture of sensitizers may also comprise at least two, more preferably at least three sensitizers according to Formula IV, 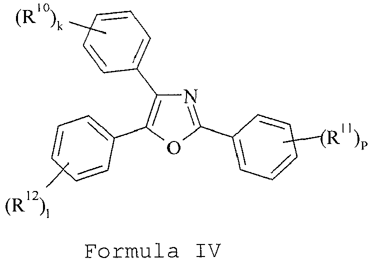 wherein
R¹⁰, R¹¹ and R¹² are independently selected from a halogen atom, an optionally substituted alkyl group, an optionally substituted aryl group, which may also be fused, an optionally substituted aralkyl group, a group -NR¹³R¹⁴ and a group -OR¹⁵,
wherein R¹³ and R¹⁴ are independently selected from a hydrogen atom, an alkyl, aryl or aralkyl group,
R¹⁵ is an optionally alkyl, aryl or aralkyl group or a hydrogen atom,
k, 1 and p are independently 0 or an integer from 1 to 5.

If one or more of R¹⁰, R¹¹ and R¹² represents an optionally substituted alkyl group, it is preferred that the alkyl group is either unsubstituted or substituted with one substituent selected from CN, COORⁿ (Rⁿ being hydrogen or alkyl).

Preferably, R¹⁰, R¹¹ and R¹² are independently selected from a halogen atom, a C1-C8 alkyl and a group -NR¹³R¹³R¹⁴, wherein R¹³ and R¹⁴ are preferably independently selected from hydrogen atoms and C1-C6 alkyl.

k,1 and p are preferably independently 0 or 1.

Oxazole derivatives of Formula IV wherein at least one of R¹⁰, R¹¹ and R¹² represents a group -NR¹³R¹⁴ wherein R¹³ and R¹⁴ are preferably independently selected from hydrogen atoms and C1-C6 alkyl, and especially preferred R¹³ = R¹⁴ = C1-C6 alkyl, are especially preferred.

The oxazole derivatives according to Formula IV can be prepared according to processes well known to the person skilled in the art. Reference is made to DE-A-1 120 875 and EP-A 129 059.

As described for the sensitizers according to Formula I and II, the following factors positively influence the preparation of a mixture of sensitizers according to Formula IV characterized in that said mixture has in 1-methoxy-2-propanol at 80°C a solubility of at least 30 wt.% and preferably a MetaStable Zone Width (MSZW) of at least 8.5 °C measured at a cooling and heating rate of 0.2°C per minute:
- higher number of different sensitizers in the mixture,
- a high solubility of the individual sensitizers,
- asymmetric structure of the sensitizer,
- asymmetric structure of the substituents R¹⁰, R¹¹ or R¹².

A mixture comprising sensitizers according to Formula I or II and Formula III, or according to Formula I or II and Formula IV, or according to Formula III and Formula IV, or according to Formula I and Formula III and Formula IV characterized in that said mixture has in 1-methoxy-2-propanol at 80°C a solubility of at least 30 wt.% and preferably a MetaStable Zone Width (MSZW) of at least 8.5°C measured at a cooling rate of 0.2°C per minute, may also be used in the present invention.

Preferably, the mixture of sensitizers described above comprises sensitizers, preferably sensitizers according to Formula II, whose absorption spectra are approximately identical, i.e. the absorption maxima of the different sensitizers making up the mixture differ not more than 25 nm, more preferably not more than 10 nm, most preferably not more than 5 nm.

The total amount of sensitizers in the photopolymerizable layer is preferably between 1 and 10 percent by weight, more preferably between 2.5 and 7.5 percent by weight relative to the total amount of non-volatile ingredients.

### Photo-initiator

The photopolymerizable layer comprises one or more photo-initiator(s), capable of initiating a polymerization reaction upon exposure with actinic light, preferably upon exposure with light having a wavelength of from 300 nm to 500 nm, most preferably upon exposure with light having a wavelength of from 350 nm to 450 nm, when used in combination with the mixture of sensitizers according to the present invention. Known photo-initiators that may be used are: aromatic ketones, aromatic onium salts, organic peroxides, thio compounds, hexaarylbisimidazole compounds, ketooxime ester compounds, borate compounds, azinium compounds, metallocene compounds, active ester compounds and compounds having a carbon-halogen bond. Many specific examples of such compounds are found in EP-A 1 091 247 (paragraph [0068] to [0095]), WO2005/111 717 (page 16 to page 31) and EP-A 1 491 536 (paragraph [0046] to paragraph [0080]).
Hexaarylbisimidazole compounds, titanocene compounds, trihalomethyl compounds or onium salts are preferably used as photo-initiators, more preferably titanocene and hexarylbisimadazole compounds. Preferred titanocene compounds are for example described in EP-A 1 491 536 (paragraph [66] and [67]).
Particularly preferred photo-initiators are hexaarylbisimidazole (HABI) compounds. Preparation methods of these compounds are described in DE 1 470 154 and their use in photopolymerizable compositions is described in EP 024 629, EP 107 792, US 4 410 621, EP 215 453 and DE 3 211 312. Preferred derivatives are e. g. 2,4,5,2',4',5'-hexaphenylbisimidazole, 2,2'-bis(2-chlorophenyl)-4,5,4',5'-tetraphenylbisimidazole, 2,2'-bis(2-bromophenyl)-4,5,4',5'-tetraphenylbisimidazole, 2,2'-bis(2,4-dichlorophenyl)-4,5,4',5'-tetraphenylbisimidazole, 2,2'-bis(2-chlorophenyl)-4,5,4',5'-tetrakis(3-methoxyphenyl)bisimidazole, 2,2'-bis(2-chlorophenyl)-4,5,4',5'-tetrakis(3,4,5-trimethoxyphenyl)-bisimidazole, 2,5,2',5'-tetrakis(2-chlorophenyl)-4,4'-bis(3,4-dimethoxyphenyl)bisimidazole, 2,2'-bis(2,6-dichlorophenyl)-4,5,4',5'-tetraphenylbisimidazole, 2,2'-bis(2-nitrophenyl)-4,5,4',5'-tetraphenylbisimidazole, 2,2'-di-o-tolyl-4,5,4',5'-tetraphenylbisimidazole, 2,2'-bis(2-ethoxyphenyl)-4,5,4',5'-tetraphenylbisimidazole and 2,2'-bis(2,6-difluorophenyl)-4,5,4',5'-tetraphenylbisimidazole.

A mixture of two or more different photo-initiators may be used in the present invention.

The amount of the photo-initiator typically ranges from 0.01 to 30 percent by weight, preferably from 0.5 to 20 percent by weight, relative to the total weight of the non volatile components of the photo-polymerizable layer.

### Co-initiator

Co-initiators, as described in EP 107 792, may be present in the photopolymerizable layer to further increase the sensitivity. Preferred co-initiators are sulfur-compounds, especially thiols like for example 2-mercaptobenzothiazole, 2-mercaptobenzoxazole or 2-mercapto-benzimidazole. Other preferred co-initiators are polythioles as disclosed in WO2006/048443 and WO2006/048445. These polythioles may be used in combination with the above described thiols, preferably with 2-mercaptobenzthialole.

The amount of co-initiator generally ranges from 0.01 to 10 % by weight, preferably from 0.1 to 2 % by weight relative to the total weight of the non volatile components of the photopolymerizable composition.

### Contrast Dye

The photopolymerizable coating of the lithographic printing plate may further comprise a colorant. The colorant can be a dye or a pigment. After development with an alkaline developer, at least part of the colorant remains in the hardened coating areas and provides a visible image, enabling an examination of the litho-graphic image on the developed printing plates. Preferred dyes and/or pigments are disclosed in WO 2005/111727. Highly preferred pigments are predispersed phthalocyanines. Their amount generally ranges from about 1 to 15 % by weight, preferably from about 2 to 7 % by weight, with respect to the total weight of the non-volatile compounds in the photosensitive composition. Particularly suitable predispersed phthalocyanine pigments are disclosed in DE 199 15 717 and DE 199 33 139. Preference is given to metal-free phthalocyanine pigments. The photopolymerizable composition may also comprise compounds that undergo discoloration or coloration upon exposure with violet light. Compounds that undergo discoloration or coloration by radicals or acids, generated by the violet exposure, are preferred. Such compounds give rise to a print-out image enabling immediate inspection of the image to be printed after exposure. Various dyes may be used for this purpose, e.g. diphenylmethane, triphenylmethane, thiazine, oxazine, xanthene, anthraquinone, iminoquinone, azo and azomethine dyes.

### Other ingredients

The photopolymerizable compostion may further comprise other ingredients such as for example surfactants, polymerization inhibitors, plasticizers, inorganic particles, low molecular weight hydrophilic compounds.

Preferred inhibitors for use in the photopolymer coating are disclosed in US 6 410 205, EP 1 288 720 and WO2005/109103.
Various surfactants may be added to the photopolymerizable layer. Both polymeric and small molecule surfactants can be used. Nonionic surfactants are preferred. Preferred nonionic surfactants are polymers and oligomers containing one or more polyether segments (such as polyethylene glycol, polypropylene glycol, and copolymer of ethylene glycol and propylene glycol). Examples of preferred nonionic surfactants are block copolymers of propylene glycol and ethylene glycol (also called block copolymer of propylene oxide and ethylene oxide); ethoxylated or propoxylated acrylate oligomers; and polyethoxylated alkylphenols and polyethoxylated fatty alcohols. The nonionic surfactant is preferably added in an amount ranging between 0.1 and 30% by weight of the coating, more preferably between 0.5 and 20%, and most preferably between 1 and 15%.

### Overcoat

On the photopolymerizable an overcoat or toplayer, also referred to as protective layer is applied, which acts as an oxygen barrier layer.

Preferred binders which can be used in the top layer are disclosed in WO2005/029190 (page 36 line 3 to page 39 line 25), US 2007/0020563 (paragraph [0158]) and EP 1 288 720 (paragraphs [0148] and [0149]). The most preferred binder for the toplayer is polyvinylalcohol. The polyvinylalcohol has preferably a hydrolysis degree ranging between 74 mol % and 99 mol %. The weight average molecular weight of the polyvinylalcohol can be determined by measuring the viscosity of a 4 % by weight aqueous solution at 20°C, as defined in DIN 53 015. This viscosity number ranges preferably between 3 and 26, more preferably between 3 and 15, most preferably between 3 and 10. Preferably, a mixture of polyvinylalcohols having a different hydrolysis and viscosity number are used.

Modified polyvinylalcohols, e.g. polyvinylalcohols having a carboxyl group and/or a sulphonic acid group may also be used, preferably together with unmodified polyvinylalcohols.

The coating thickness of the top layer is preferably between 0.25 and 1.75 g/m², more preferably between 0.30 and 1.30 g/m², most preferably between 0.40 and 1.00 g/m². In a most preferred embodiment of the present invention, the top layer has a coating thickness between 0.25 and 1.75 g/m² and comprises a polyvinylalcohol having a hydrolysis degree ranging between 74 mol % and 99 mol % and a viscosity number as defined above ranging between 3 and 26.

Besides acting as barrier for oxygen, the overcoat layer must be easily removable during processing and be sufficiently transparent for the actinic radiation, e.g. from 300 to 500 nm.

The overcoat layer may comprise other ingredients such as anionic surfactants, e.g. sodium alkyl sulphate or sodium alkyl sulphonate; amphoteric surfactants, e.g. alkylaminocarboxylate and alkylamino-dicarboxylate; non-ionic surfactants, e.g. polyoxyethylene alkyl phenyl ether; additives, e.g. alkoxylated alkylene diamines, disclosed in EP 1 085 380 (paragraph [0021] and [0022]); glycerine, inorganic particles, pigments, etc.

### Exposure

The method of making a printing plate according to the present invention utilizes a laser emitting actinic light. Preferably a laser emitting light having a wavelength of from 300 to 500 nm, more preferably of from 350 to 450 nm and preferably having an energy density measured on the surface of the plate of 150 µJ/cm² or less, more preferably of 100 µJ/cm² or less.

Preferably laser diodes, highly preferably, commercially available InGaN-based semiconductor laser diodes having a wavelength of 405 nm, are used to expose the lithographic printing plate precursors. The power of the laser diodes may be between 5 and 200 mW, preferably between 20 mW and 150 mW, most preferably between 50 mW and 80 mW. One laser diode may be used to expose the lithographic printing plate precursors, but also multiple laser diodes may be used.

Three major categories of plate-setters, i.e. apparatuses wherein the lithographic printing plates are image-wise exposed with a laser beam, are known and may be used in the present invention: flat bed, internal drum (ITD) and external drum (XTD) type plate-setters.

A particularly preferred plate-setter, an external drum apparatus emitting one or more scanning laser beams having a wavelength between 390 and 420 nm and an energy density, measured on the surface of the precursor, of 100 µJ/cm² or less, and a method of preparing a printing plate using the plate-setter is disclosed in EP-A 1 843 203. The pixel dwell time of the scanning laser beam is preferably from 0.5 to 10 microseconds.

Also suitable is the apparatus described in US2006/0001849 comprising an imaging head comprising a plurality of laser diodes emitting light of a wavelength between 350 nm and 450 nm. Since each spot on the lithographic printing plate to be exposed receives light, emitted from a plurality of laser diodes, low power laser diodes can be used.

The method disclosed in WO2005/11171 comprising image-wise exposing a photopolymerizable lithographic printing plate precursor with an imaging time per pixel of 1 milliseconds or less using a laser light with an emission wavelength of from 250 nm to 420 nm may also be used in the present invention.

### Pre-heat

The lithographic printing plates are optionally subjected to a pre-heat step. In such a pre-heat step, performed after image-wise exposure and before development, the plate precursor is heated to enhance or to speed-up the polymerization and/or crosslinking reaction. The pre-heat step may improve the printing properties, e.g. rendition of small dots or run length, of the printing plate. There is no particular time limit between exposure and pre-heat but the pre-heat step is usually carried out within a time period after exposure of less than 10 minutes, preferably less than 5 minutes, more preferably less than 1 minutes, most preferably the pre-heat is carried out immediately after the image-wise exposing, i.e. within less than 30 seconds. In this heating step, the precursor is heated at a temperature of preferably 80°C to 150°C, more preferably of 90 to 140°C, most preferably of 100°C to 130°C during preferably 1 seconds to 1 minute, more preferably 5 seconds to 45 seconds, most preferably 10 seconds to 30 seconds. The pre-heating unit is preferably provided with heating elements such as IR-lamps, UV-lamps, heated air, a heated metal or silicone rubber roll, etc.

The pre-heating unit is preferably connected with the development apparatus to enable automatic transport from the pre-heating unit to the development apparatus in a single apparatus. Preferably a cooling section is provided between the pre-heating section and the development section of said single apparatus.

The pre-heating unit, the development unit may also be connected to the plate-setter to enable automatic transport of the exposed precursor to first the pre-heating unit and then the developing unit. Again, a cooling section may be provided between the pre-heating unit and the development unit.

### Development

Photopolymerizable printing plate precursors are developed in an alkaline aqueous solution. In the development step, the complete overcoat layer and the unexposed part of the photosensitive layer are removed. The removal (wash-off) of the overcoat layer and the development of the photosensitive layer can be done in two separate steps in this order, but can also be done in one step simultaneously. Preferably the overcoat layer is washed-off with water before the development step. The wash-off can be done with cold water, but it is preferred to use hot water to accelerate the process.
The developer solution preferably is an aqueous alkaline solution having a pH from 9 to 14, a pH from 11.5 to 13.5 being particularly preferred. The developer solution can contain a small percentage, preferably less than 5 wt.%, of an organic, water-miscible solvent. To adjust the pH of the solution, an alkali hydroxide is preferably used.

Examples of preferred, additional ingredients of the developer solution comprise alone or in combination alkali phosphates, alkali carbonates, alkali bicarbonates, an organic amine compound, alkali silicates, buffering agents, complexants, defoamers, surface active agents and dyes, as described in e.g. EP-A 1 273 972, EP-A 1 521 123, WO2005/11171 and the EP-As 1 722 274 and 1 722 275, but the suitable ingredients are not limited hereto and further ingredients can be used.

The developer preferably comprises a surfactant of formula (V):

R^{a}-R^{b} Formula V

wherein
R^{a} represents a hydrophobic aryl group having in addition to
R^{b} at least two substituents different to hydrogen,
R^{b} represents a hydrophilic group comprising a polyethyleneoxy group with at least 6 ethyleneoxy units.

The aryl group of R^{a} may be a homo- or heteroaryl group and may be a single ring, a condensed or annealed system. Preferably the aryl group is a single ring and particularly preferred it is a phenyl ring. Particularly preferred, R^{a} represents an aryl group, in particular a phenyl group, wherein said aryl group or phenyl group respectively is substituted by 2 or three substituents selected from a phenylethyl group and/or a t-butyl group and most preferred the surfactant is of general formula (Va): 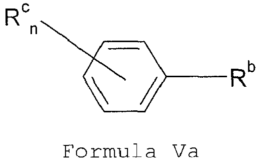 wherein
- R^{b}: has the same meaning as in Formula V,
- R^{c}: represents a 1,1-phenylethyl or a t-butyl group, in particular a 1,1-phenylethyl group, and
- n: means 2 or 3, in particular 3.

Besides the polyethyleneoxy group, R^{b} may comprise polypropyleneoxy blocks, preferably however R^{b} only consists of a polyethyleneoxy chain.

Particularly preferred surfactants of formula (Va) are given by the following examples.

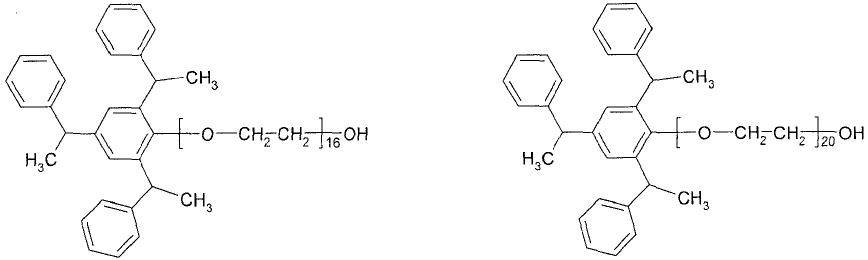

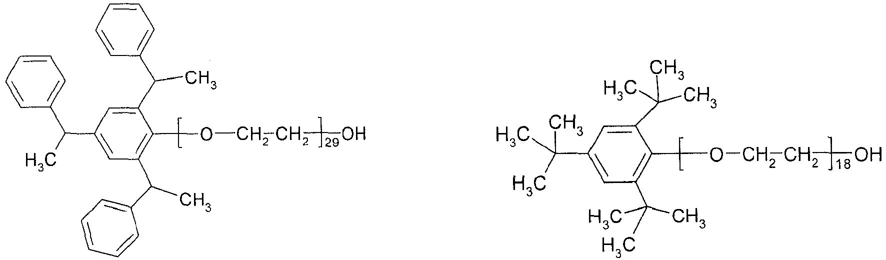

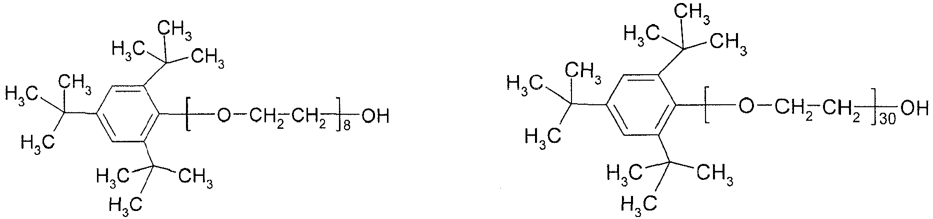

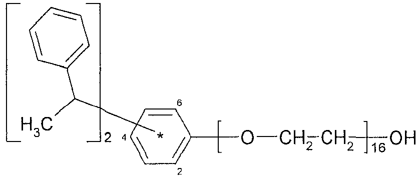

Preferably, the developer also comprises a surfactant according to formulae (VIa), (VIb) or (IVc).

HO-R^{d} Formula VIa

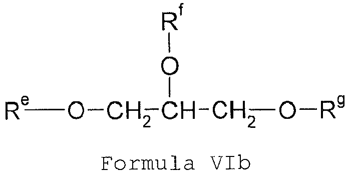

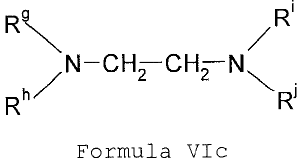

wherein R^{d} to R^{j} mutually independently consist of polyoxyethylene and polyoxypropylene groups, and preferably of Z¹ and Z² blocks being arranged as -Z¹-Z²-H, -Z²-Z¹-H, -Z¹-Z²-Z¹-H or -Z²-Z¹-Z²-H, wherein Z¹ represents a polyoxyethylene block and Z² polyoxypropylene block.

The polyoxyethylene block (hereinafter also called ethyleneoxide block or EO block) represents a hydrophilic moiety and the polyoxypropylene block (hereinafter also called propyleneoxide block or PO block) represents a hydrophobic moiety.

Preferably, the surfactants of formulae (VIa), (VIb) or (VIc) have a total molecular weight of the PO block(s) of at least 2 000 g/mol, in particular from 2 200 to 6 000 g/mol and comprise 25 to 55 wt.% ethyleneoxide based on the total molecular weight of the PO blocks and the EO blocks in the molecule, in particular 30 to 50 wt.% ethyleneoxide.

Preferred surfactants according to Formulae IVa, IVb or IVc are Pluronic PE 9400®, Pluronic PE 10500®, Pluronic PE 10400®, Pluronic PE 10300® and Synperonic T/904®.

Preferred ratios by weight of the surfactant of formula V or Va to the surfactant of formulae VIa, VIb or VIc are 1:1 to 1:80, in particular from 1:2 to 1:50, and most preferred from 1:4 to 1:20.

The method of development employed is not particularly limited, and may be conducted by immersing and shaking the plate in a developer, physically removing non-image portions while being dissolved in a developer by means of e. g. a brush, or spraying a developer onto the plate so as to remove non-image portions. The time for development is selected so that the non-image portions are adequately removed, and is optionally selected within a range of 5 seconds to 10 minutes. Development can be carried out at room temperature or at elevated temperatures, for example between 25°C and 50°C, more preferably between 25°C and 40°C.

After development the printing plate may be subjected to several well known post-development treatments (e.g. gumming, drying, baking, rewashing, etc.).

### EXAMPLES

### MATERIALS

All materials used in the examples were readily available from standard sources such as Aldrich Chemical Co. (Belgium) and Acros (Belgium) unless otherwise specified.
- PVA-1: partially hydrolyzed poly(vinyl alcohol); degree of saponification is 88 mol %; viscosity of a 4 wt % aqueous solution at 20 °C is 4 mPa•s.
- PVA-2: fully hydrolyzed poly(vinyl alcohol); degree of saponification is 98 mol %; viscosity of an aqueous solution of 4 wt % at 20 °C is 6 mPa•s.
- PVA-3: partially hydrolyzed poly(vinyl alcohol); degree of saponification is 88 mol %; viscosity of an aqueous solution of 4 wt % at 20 °C is 8 mPa•s.
- Acticide LA 1206, a biocide commercially available from THOR.
- Lupasol P: 50 wt % solution of a polyethylene imine in water, commercially available from BASF.
- Lutensol A8: 90 wt % solution of a surface active agent, commercially available from BASF.
- Edaplan: 10 wt % solution of Edaplan LA 411, a modified siloxane-glycol copolymer commercially available from MUNZING CHEMIE GMBH, in Dowanol PM.
- Dowanol PM: 1-methoxy-2-propanol, commercially available from DOW CHEMICAL COMPAGNY.
- FST426R, monomer: a solution containing 89.8.2 wt % in MEK of a reaction product from 1 mole of 2,2,4-trimethylhexamethylenediisocyanate and 2 moles of hydroxyethylmethacrylate (viscosity 3.30 mm²/s at
   25 °C).
- Mono Z1620, monomer: a solution in MEK containing 30.3 wt % of a reaction product from 1 mole of hexamethylenediisocyanate, 1 mole of 2-hydroxyethylmethacrylate and 0.5 mole of 2-(2-hydroxyethylpiperidine (viscosity 1.7 mm² at 25 °C).
- MEK: methylethylketone.
- Heliogene Blue: Heliogene Blue D 7490 dispersion (10.08 wt % in Dowanol PM, viscosity 7.0 mm²/s at 25 °C), trade name of BASF AG, as defined in EP 1 072 956.
- Hostanox 03: a phenolic antioxidant, commercially available from Clariant.
- HABI: 2-(2-chlorophenyl)-4,5-diphenyl bisimidazole, commercially available from SUMITOMO.
- MBT: 2-mercaptobenzithiazole.
- KL7177, binder: a 33.20 wt % solution in MEK of a methacrylic acid - metylmethacrylate copolymer, commercially available from Clariant.
- Sensitizer: a mixture consisting of 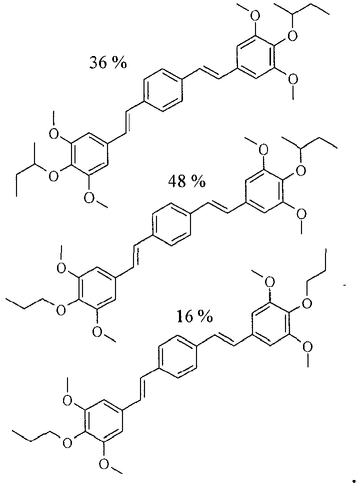
- Pluronic PE9400 blockcopolymer of ethyleneoxyde and propyleneoxyde having an etyleneoxyde content of 40 % with a molar mass of about 4600, commercially available from BASF.
- Emulsogen TS160, a 2,4,6-tris-(1-phenylethyl)-polyglycolether having approximately 15 ethyleneoxyde units, commercially available from CLARIANT.
- ANTIFOAM BAN MS575, an antifoam agent commercially available from MUNZING CHEMIE GMBH.

### EXAMPLE 1

### Preparation of aluminum support AS-01

A 0.3 mm thick aluminum foil was degreased by spraying with an aqueous solution containing 26 g/l NaOH at 65°C for 2 seconds and rinsed with demineralised water for 1.5 seconds. The foil was then electrochemically grained during 10 seconds using an alternating current in an aqueous solution containing 15 g/l HCl, 15 g/1 SO₄²⁻ ions and 5 g/l Al³⁺ ions at a temperature of 37°C and a current density of about 100 A/dm². Afterwards, the aluminum foil was desmutted by etching with an aqueous solution containing 5.5 g/l NaOH at 36°C for 2 seconds and rinsed with demineralised water for 2 seconds. The foil was subsequently subjected to anodic oxidation during 15 seconds in an aqueous solution containing 145 g/l of sulfuric acid at a temperature of 50°C and a current density of 17 A/dm², then washed with demineralised water for 11 seconds and post-treated for 3 seconds (by spray) with a solution containing 2.2 g/l of Polyvinyl phosphonic acid at 70°C, rinsed with demineralised water for 1 seconds and dried at 120°C for 5 seconds.

The aluminum support AS-01 thus obtained was characterized by a surface roughness Rₐ of 0.35-0.4 µm (measured with interferometer NT1100) and had an anodic weight of 3.0 g/m².

### Preparation of aluminum support AS-02

A 0.3 mm thick aluminum foil was degreased by spraying with an aqueous solution containing 26 g/l NaOH at 65°C for 2 seconds and rinsed with demineralised water for 1.5 seconds. The foil was then electrochemically grained during 10 seconds using an alternating current in an aqueous solution containing 15 g/l HCl, 15 g/l SO₄²⁻ ions and 5 g/l Al³⁺ ions at a temperature of 37°C and a current density of about 100 A/dm². Afterwards, the aluminum foil was desmutted by etching with an aqueous solution containing 5.5 g/l NaOH at 36°C for 2 seconds and rinsed with demineralised water for 2 seconds. The foil was subsequently subjected to anodic oxidation during 15 seconds in an aqueous solution containing 145 g/l of sulfuric acid at a temperature of 50°C and a current density of 17 A/dm², then washed with demineralised water for 11 seconds and dried at 120°C for 5 seconds.

The aluminum support AS-02 thus obtained was characterized by a surface roughness Rₐ of 0.35-0.4 µm (measured with interferometer NT1100) and had an anodic weight of 3.0 g/m².

### Overcoat layer OC-01

The overcoat layer (top layer) OC-01 is applied from an aqueous solution of which the composition is defined in table I. The wet coating thickness is 45 µm. After drying at 110 °C for 2 minutes a dry coverage weight of 1.75 g/m² is obtained.

**Table I**

| Ingredients | g |
|---|---|
| PVA-1 | 17.04 |
| PVA-2 | 14.87 |
| PVA-3 | 7.43 |
| Acticide LA 1206 | 0.08 |
| Lupasol P | 0.40 |
| Lutensol A8 | 0.42 |
| Water | 960 |

### Photo layers PL-01 to PL-03

The composition of the coating solutions for the photo layers PL-01 to PL-03 is shown in table II. The wet coating thickness is 20 µm. After drying, a dry coating weight of 1.5 g/m² is obtained.

**Table II**

| Ingredients | PL-01 | PL-02 | PL-03 |
|---|---|---|---|
| | (g) | (g) | (g) |
| Edaplan | 0.85 | 0.85 | 0.85 |
| MEK | 214.40 | 213.60 | 212.81 |
| FLUOMIX | 2.98 | 2.98 | 2.98 |
| Dowanol PM | 505.49 | 505.49 | 505.49 |
| FST426R | 12.41 | 11.37 | 10.35 |
| Mono Z1620 | 132.39 | 121.41 | 110.43 |
| Heliogene blue | 67.46 | 67.46 | 67.46 |
| Hostanox 03 | 0.43 | 0.43 | 0.43 |
| HABI | 3.83 | 3.83 | 3.83 |
| MBT | 0.26 | 0.26 | 0.26 |
| KL7177 | 59.53 | 72.33 | 85.13 |
| | | | |
| wt.% binder* | 23.25% | 28.25% | 33.25% |
| wt.% monomers* | 60.3% | 55.3% | 50.3% |
| wt.% monomers/ wt.% binder | 2.59 | 1.96 | 1.51 |

| | | | |
|---|---|---|---|
| * wt.% relative to the total solid weight of the photo layer | | | |

### Printing Plate Precursors PPP-01 to PPP-06

The photo layers PL-01 to PL-03 were coated onto the aluminum substrates AS-01 or AS-02. On top of the photo layer, the overcoat layer OC-01 is applied. The following printing plate precursors are obtained:

**Table III**

| | Aluminum substrate | Photo layer | Overcoat layer |
|---|---|---|---|
| PPP-01 | AS-1 | PL-01 | OC-01 |
| PPP-02 | AS-1 | PL-02 | OC-01 |
| PPP-03 | AS-1 | PL-03 | OC-01 |
| PPP-04 | AS-2 | PL-01 | OC-01 |
| PPP-05 | AS-2 | PL-02 | OC-01 |
| PPP-06 | AS-2 | PL-03 | OC-01 |

Exposure of the printing plate precursors PPP-01 to P PP-06

Exposure was carried out on an Agfa Galileo VXT platesetter at 2400 dpi. The sensitivity, i.e. right exposure, was determined for each printing plate precursor. The sensitivity is defined as the exposure energy density (in µJ/cm²) needed to obtain (after preheat and processing) at the same time:
- a tone range of 3%-97% at 200 lines per inch (lpi) with Agfa Balanced Screening from Agfa Graphics NV on the plate (visual inspection with a 50x magnification hand microscope);
- a good reproduction of both the positive and negative 1-pixel scan lines on the plate in both the fast-scan and the cross-scan direction (visual inspection with a 50x magnification hand microscope);
- a stable reproduction of the 3% dots, at 200 lpi with Agfa Balanced Screening, from Agfa Graphics NV, on the printed sheet up to 5000 impressions (visual inspection with 8x magnification loupe), even at an underexposure level of -0.05 log It vs. the "right exposure";

Two test fields were exposed on each printing plate to evaluate the dot loss after printing:
- test field 1 = field consisting of isolated 2x2 pixel microdots arranged according to the Bayer dispersed dot placement algorithm (see Bayer, B.E., "An optimum method for two-level rendition of continuous-tone pictures", Proceedings IEE International Conference on Communications, Conference Record, 26, pages 11-15, 1973) and with a (theoretical) dot coverage of 25%;
- test field 2 = 40% at 200lpi with Agfa Balanced Screening, from Agfa Graphics NV.

### Pre-heat

After exposure a pre-heat treatment was performed in the pre-heat section of a VSP85 processor available from Agfa Graphics NV (speed = 1.2 m/min; temperature, measured on the backside of the printing plate precursor, = 110 °C).

### Processing

After pre-heat, the printing plate precursors were developed in the developing section of the VSP85 processor, filled with a developer having the composition shown in Table IV at a temperature of 24°C and a dwell time of 24 seconds.

**Table IV**

| Ingredient | amount |
|---|---|
| Deminerilized water | 625.000 ml |
| PE9400; 25 wt% in water | 206.400 g |
| Emulsogen TS160; 25 wt% in water | 12.000 ml |
| FOAM BAN MS575 | 0.500 g |
| Sodium gluconate | 7.500 g |
| Potassium metasilicate; 41.5 wt% in water | 43.420 ml |
| water | until 1000 ml |
| pH | 12.7-12.9 |

After development, the plates were rinsed and gummed, the latter with a 1:1 diluted Agfa RC795 gum, available from Agfa Graphics NV.

### Printing

Printing on machine-coated paper (90 g/m²) was performed on a Heidelberg Speedmaster SM74 sheetfed press with K+E 700 black ink (trademark of K+E) and 4% Agfa Prima FS303SF + 10% IPA as fountain solution. A compressible type of blanket was used. The following start-up procedure was used : first 5 revolutions with the dampening form rollers engaged, then 5 revolutions with both the dampening and ink form rollers engaged, then start printing. The printing target density was 1.75 +/- 0.05 as measured with a GretagMacBeth D186 or D19c densitometer. A pre-run on the press was performed with Agfa N91v plates having the same image content in order to bring the press into stable printing conditions with the density properly set and adjusted over the whole width of the printed sheet.

10 000 Sheets were printed. During this press run print samples were collected after respectively 1 000, 5 000 and 10 000 impressions.

After the press run, the plates were cleaned with Agfa AutowashPlus in order to completely remove the ink from the plate's surface.

### Dot loss measurement

The two exposed test fields described above were measured with a Techkon DMS 910 plate reader (settings: AM Screening/Positive/Media = N91v), before and after printing. The differences in dot coverage of the test fields 1 (TF01) and 2 (TF02) before and after printing (i.e. dot loss) are given in Table V.

**Table V**

| PPP | S* (µJ / cm²) | Dot loss TF01 | Dot loss TF02 | monomers/binder ratio | Alu support |
|---|---|---|---|---|---|
| PPP-01 (COMP) | 33 | 11.2 | 6.2 | 2.59 | AS-01 |
| PPP-02 (COMP) | 33 | 9.4 | 6.0 | 1.96 | AS-01 |
| PPP-03 (COMP) | 41 | 8 | 5.8 | 1.51 | AS-01 |
| PPP-04 (COMP) | 37 | 6.3 | 4.1 | 2.59 | AS-02 |
| PPP-05 (INV) | 41 | 5.5 | 3.0 | 1.96 | AS-02 |
| PPP-06 (INV) | 47 | 4.6 | 2.8 | 1.51 | AS-02 |

| | | | | | |
|---|---|---|---|---|---|
| * sensitivity | | | | | |

The printing plate precursors PPP-05 and PPP-06 are not anymore part of the invention.

From Table V it is clear that the plate sensitivity decreases (higher values) when an aluminum substrate without a post-anodic treatment (PAT) is used. Moreover, the sensitivity also decreases when a lower monomer(s)/binder ratio is used. However, the plate sensitivity values are still quite acceptable in the context of the typical violet imaging equipment for the commercial printing market (border value = 150 µJ/cm²).

At the same time it is clear that the dot loss problems are largely reduced by using an aluminum substrate without a PAT and a lower monomer(s)/binder ratio. For high-quality commercial printing work containing AM-screened images (equal to or higher than 200 lpi) the rendable tone range on the printed sheet needs to be at least 3 % - 92 %. At the same time dot loss values of higher than 3 % are not acceptable anymore (see test field 2). When the printed job contains FM-screened images, typically consisting of 20 µm microdots, dot loss values higher than 6 % are not acceptable anymore (see test field 1).

From Table IV is is clear that these conditions can only be realized with the inventive printing plates obtained from printing plate precursors comprising an aluminum support without a post-anodic treatment and a monomer/binder ratio between 1.0 and 2.0.

### EXAMPLE 2

### Photo layers PL-04 to PL-13

The composition of the coating solutions for the photo layers PL-04 to PL-13 is shown in table VI. The wet coating thickness is 20 µm. After drying, a dry coating weight of 1.5 g/m² is obtained.

**Table VI**

| Ingredients | PL-04 | PL-05 | PL-06 | PL-07 | PL-08 |
|---|---|---|---|---|---|
| | (g) | (g) | (g) | (g) | (g) |
| Edaplan | 0.85 | 0.85 | 0.85 | 0.85 | 0.85 |
| MEK | 213.60 | 213.60 | 213.60 | 213.60 | 213.60 |
| FLUOMIX | 2.98 | 2.98 | 2.98 | 2.98 | 2.98 |
| Dowanol PM | 505.49 | 505.49 | 505.49 | 505.49 | 505.49 |
| FST426R | 13.06 | 12.55 | 12.04 | 11.37 | 11.01 |
| Mono Z1620 | 139.53 | 134.04 | 128.55 | 121.41 | 117.57 |
| Heliogene blue | 67.46 | 67.46 | 67.46 | 67.46 | 67.46 |
| Hostanox 03 | 0.43 | 0.43 | 0.43 | 0.43 | 0.43 |
| HABI | 3.83 | 3.83 | 3.83 | 3.83 | 3.83 |
| MBT | 0.26 | 0.26 | 0.26 | 0.26 | 0.26 |
| KL7177 | 51.20 | 57.61 | 64.01 | 72.33 | 76.81 |
| | | | | | |
| wt.% binder* | 20% | 22.5% | 25% | 28.25% | 30% |
| wt.% monomers* | 63.55% | 61.05% | 58.55% | 55.3% | 53.55% |
| wt.% monomers/ wt.% binder | 3.18 | 2.71 | 2.34 | 1.96 | 1.785 |

| Ingredients | PL-09 | PL-10 | PL-11 | PL-12 | PL-13 |
|---|---|---|---|---|---|
| | (g) | (g) | (g) | (g) | (g) |
| Edaplan | 0.85 | 0.85 | 0.85 | 0.85 | 0.85 |
| MEK | 213.60 | 213.60 | 212.13 | 211.74 | 211.34 |
| FLUOMIX | 2.98 | 2.98 | 2.98 | 2.98 | 2.98 |
| Dowanol PM | 505.49 | 505.49 | 505.49 | 505.49 | 505.49 |
| FST426R | 10.49 | 9.98 | 9.48 | 8.96 | 8.45 |
| Mono Z1620 | 112.08 | 106.59 | 101.10 | 95.61 | 90.12 |
| Heliogene blue | 67.46 | 67.46 | 67.46 | 67.46 | 67.46 |
| Hostanox 03 | 0.43 | 0.43 | 0.43 | 0.43 | 0.43 |
| HABI | 3.83 | 3.83 | 3.83 | 3.83 | 3.83 |
| MBT | 0.26 | 0.26 | 0.26 | 0.26 | 0.26 |
| KL7177 | 83.21 | 89.61 | 96.01 | 102.41 | 108.81 |
| | | | | | |
| wt.% binder* | 32.5% | 35% | 37.5 % | 40 % | 42.5 % |
| wt.% monomers* | 51.05% | 48.55% | 46.05% | 43.55% | 41.05% |
| wt.% monomers/ wt.% binder | 1.57 | 1.39 | 1.23 | 1.09 | 0.97 |

| | | | | | |
|---|---|---|---|---|---|
| * wt.% relative to the total solid weight of the photo layer | | | | | |

### Printing Plate Precursors PPP-07 to PPP-16

The photo layers PL-04 to PL-13 were coated onto the aluminum substrates AS-01 or AS-02 described in Example 1. On top of the photo layers, the overcoat layer OC-01 described in Example 1 is applied. The following printing plate precursors are obtained:

**Table VII**

| | Alu support | Photo layer | Overcoat layer |
|---|---|---|---|
| PPP-07 | AS-02 | PL-04 | OC-01 |
| PPP-08 | AS-02 | PL-05 | OC-01 |
| PPP-09 | AS-02 | PL-06 | OC-01 |
| PPP-10 | AS-02 | PL-07 | OC-01 |
| PPP-11 | AS-02 | PL-08 | OC-01 |
| PPP-12 | AS-02 | PL-09 | OC-01 |
| PPP-13 | AS-02 | PL-10 | OC-01 |
| PPP-14 | AS-02 | PL-11 | OC-01 |
| PPP-15 | AS-02 | PL-12 | OC-01 |
| PPP-16 | AS-02 | PL-13 | OC-01 |

### Exposure, processing, printing

Exposure, processing and printing of the printing plate precursors PPP-07 to PPP-16 was performed as in Example 1.

### Dot loss measurement

Dot loss after printing was measured as described in Example 1. The results are shown in Table VIII.

**Table VIII**

| PPP | S* (µJ/cm²) | Dot loss (TF01) | Alu support | monomers/binder ratio |
|---|---|---|---|---|
| PPP-07 (COMP) | 31 | 6.7 | AS-02 | 3.180 |
| PPP-08 (COMP) | 35 | 6.3 | AS-02 | 2.710 |
| PPP-09 (COMP) | 37 | 6.1 | AS-02 | 2.340 |
| PPP-10 (INV) | 41 | 5.6 | AS-02 | 1.960 |
| PPP-11 (INV) | 44 | 5.0 | AS-02 | 1.785 |
| PPP-12 (INV) | 47 | 4.5 | AS-02 | 1.570 |
| PPP-13 (INV) | 63 | 4.4 | AS-02 | 1.390 |
| PPP-14 (INV) | 85 | 4.6 | AS-02 | 1.230 |
| PPP-15 (INV) | 121 | 4.5 | AS-02 | 1.090 |
| PPP-16 (COMP) | 195 | 4.5 | AS-02 | 0.970 |

| | | | | |
|---|---|---|---|---|
| ^{*} Sensitivity | | | | |

The printing plate precursors PPP-10 and PPP-13 to PPP-15 are not anymore part of the invention.

From Table VIII it is clear that the dot loss of the inventive printing plates (less than or equal to 6.0 for measurements on Test Field 01 (TF 01)) is acceptable for commercial printing applications. From Table VIII it is also clear that the plate sensitivity goes down (higher values) at lower monomer(s)/binder ratio's. When going lower than a monomers/binder ratio of 1.00 the printing plate precursors still can be exposed on a violet platesetter for commercial printing applications, but at a considerable throughput penalty.

## Claims

1. A method of preparing a lithographic printing plate precursor comprising the steps of:
- providing an aluminum support;
- graining and anodizing the aluminum support;
- without applying a hydrophilic layer on the anodized aluminum support, coating a composition which is photopolymerizable upon absorption of light having a wavelength in the range of from 350 nm to 450 nm and comprising a polymerizable monomer or oligomer, a binder and a photo-initiator on the grained and anodized aluminum support to form a photopolymerizable layer;
- coating an overcoat on the photopolymerizable layer;
**characterized in that** the ratio of the total solid amount of polymerizable monomer and oligomer to the total solid amount of binder is from 1.55 to 1.95.

2. The method of preparing a lithographic printing plate precursor according to claim 1 wherein the total solid amount of binder is less than 40 weight % relative to the total solid weight of the composition.

3. The method of preparing a lithographic printing plate precursor according to any one of claims 1 to 2 wherein the photo-initiator is a hexaarylbisimidazole compound.

4. The method of preparing a lithographic printing plate precursor according to any one of claims 1 to 3 wherein the composition further contains a mixture of sensitizers according to Formula I, 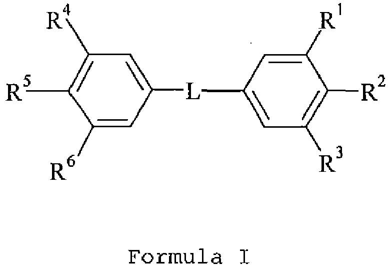 wherein
R¹ to R⁶ independently represent a hydrogen atom, an optionally substituted alkyl group, an optionally substituted alkoxy group, a cyano group, a halogen atom, a dialkylamino group, an alkylarylamino group or a diarylamino group;
L is a divalent linking group selected from the list consisting of: 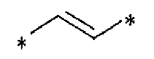 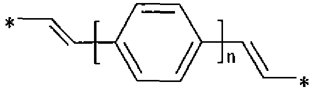 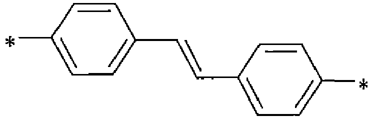 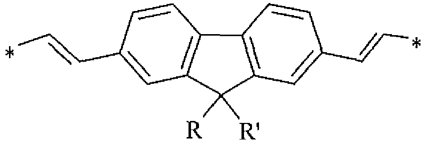 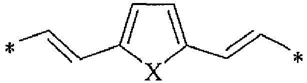 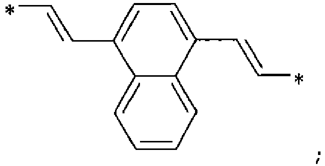
n is an integer from 0 to 2;
X represents S, O or NR^{x};
* represents the linking positions of the linking group L to the phenyl groups of Formula I;
R, R' and R^{x} represent an optionally substituted alkyl group.

5. A method of preparing a lithographic printing plate comprising the steps of:
- providing a printing plate precursor prepared according to any one of claims 1 to 4;
- exposing said precursor with a laser having a wavelength of from 350 to 450 nm;
- processing said exposed precursor in a developer.

6. The method according to claim 5 wherein a pre-heat step is carried out after exposure and before developing the precursor.

7. The method according to claims 5 or 6 wherein the developer is an aqueous solution having a pH of from 9.0 to 14.0.

8. The method according to claim 7 wherein the aqueous solution comprises a surfactant of formula (V):
R^{a}-R^{b} Formula V
wherein
R^{a} represents a hydrophobic aryl group having in addition to R^{b} at least two substituents different to hydrogen,
R^{b} represents a hydrophilic group comprising a polyethyleneoxy group with at least 6 ethyleneoxy units.

9. The method according to claim 7 or 8 wherein the aqueous solution comprises a surfactant of the formula (Va) 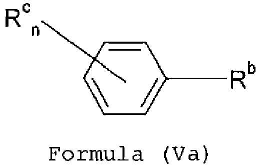 wherein
R^{b} has the same meaning as in Formula V,
R^{c} represents a 1,1-phenylethyl or a t-butyl group, in particular a 1,1-phenylethyl group, and
n means 2 or 3, in particular 3.

10. The method according to any one of claims 5 to 9 wherein the exposure energy density of the laser measured on the plate surface is less than or equal to 150 µJ/cm².

## Patentansprüche

1. Ein Verfahren zur Herstellung einer lithografischen Druckplattenvorstufe, das die folgenden Schritte umfasst:
- Bereitstellen eines Aluminiumträgers,
- Aufrauen und Anodisieren des Aluminiumträgers,
- ohne Auftrag einer hydrophilen Schicht auf den anodisierten Aluminiumträger, Beschichtung des aufgerauten und anodisierten Aluminiumträgers mit einer Zusammensetzung, die bei Absorption von Licht mit einer Wellenlänge im Bereich von 350 nm bis 450 nm fotopolymerisierbar ist und ein polymerisierbares Monomer oder Oligomer, ein Bindemittel und einen Fotoinitiator enthält, zur Bildung einer fotopolymerisierbaren Schicht,
- Beschichtung der fotopolymerisierbaren Schicht mit einem Überzug,
**dadurch gekennzeichnet, dass** das Verhältnis der Gesamtfeststoffmenge an polymerisierbarem Monomer und Oligomer zur Gesamtfeststoffmenge an Bindemittel zwischen 1,55 und 1,95 liegt.

2. Das Verfahren zur Herstellung einer lithografischen Druckplattenvorstufe nach Anspruch 1, wobei die Gesamtfeststoffmenge an Bindemittel bei weniger als 40 Gew.-%, bezogen auf das Gesamtfeststoffgewicht der Zusammensetzung, liegt.

3. Das Verfahren zur Herstellung einer lithografischen Druckplattenvorstufe nach einem der Ansprüche 1 bis 2, wobei der Fotoinitiator eine Hexaarylbisimidazolverbindung ist.

4. Das Verfahren zur Herstellung einer lithografischen Druckplattenvorstufe nach einem der Ansprüche 1 bis 3, wobei die Zusammensetzung ferner ein Gemisch aus Sensibilisierungsmitteln gemäß Formel I enthält, 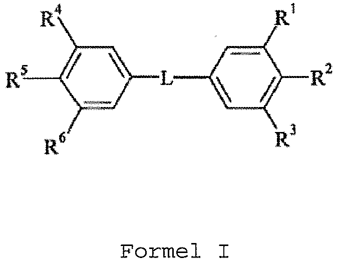 in der
R¹ bis R⁶ unabhängig voneinander ein Wasserstoffatom, eine gegebenenfalls substituierte Alkylgruppe, eine gegebenenfalls substituierte Alkoxygruppe, eine Cyangruppe, ein Halogenatom, eine Dialkylaminogruppe, eine Alkylarylaminogruppe oder eine Diarylaminogruppe bedeuten,
L eine divalente Verbindungsgruppe bedeutet, ausgewählt aus der Liste bestehend aus: 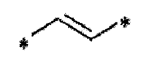 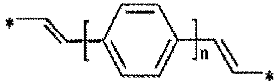 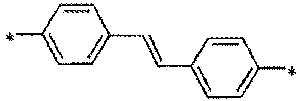 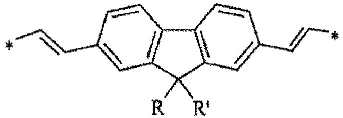 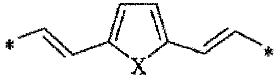 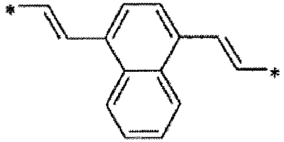
in denen
n eine ganze Zahl zwischen 0 und 2 bedeutet,
X S, O oder NR^{x} bedeutet,
* die Bindungsstellen der Verbindungsgruppe L an die Phenylgruppen der Formel I bedeutet,
R, R' und R^{x} eine gegebenenfalls substituierte Alkylgruppe bedeuten.

5. Ein Verfahren zur Herstellung einer lithografischen Druckplatte, das die folgenden Schritte umfasst:
- Bereitstellen einer nach einem der Ansprüche 1 bis 4 hergestellten Druckplattenvorstufe,
- Belichtung der Vorstufe mit einem Laser mit einer Wellenlänge zwischen 350 und 450 nm,
- Verarbeitung der belichteten Vorstufe in einem Entwickler.

6. Das Verfahren nach Anspruch 5, wobei anschließend an die Belichtung und vor der Entwicklung der Vorstufe eine Vorwärmstufe durchgeführt wird.

7. Das Verfahren nach den Ansprüchen 5 oder 6, wobei der Entwickler eine wässrige Lösung mit einem pH zwischen 9,0 und 14,0 ist.

8. Das Verfahren nach Anspruch 7, wobei die wässrige Lösung ein Tensid der Formel (V) enthält:
R^{a}-R^{b} Formel V
in der
R^{a} eine hydrophobe Arylgruppe bedeutet, die außer R^{b} mindestens zwei Substituenten, die kein Wasserstoffatom sind, enthält, R^{b} eine hydrophile Gruppe, die eine Polyethylenoxygruppe mit mindestens 6 Ethylenoxyeinheiten enthält, bedeutet.

9. Das Verfahren nach Anspruch 7 oder 8, wobei die wässrige Lösung ein Tensid der Formel (Va) enthält: 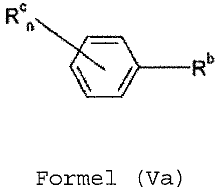 in der
R^{b} die gleiche Bedeutung wie in Formel V hat,
R^{c} eine 1,1-Phenylethylgruppe oder eine t-Butylgruppe, insbesondere eine 1,1-Phenylethylgruppe, bedeutet, und
n 2 oder 3, insbesondere 3, bedeutet.

10. Das Verfahren nach einem der Ansprüche 5 bis 9, wobei die auf der Plattenoberfläche gemessene Belichtungsenergiedichte des Lasers kleiner oder gleich 150 *µ*J/cm² ist.

## Revendications

1. Procédé pour la fabrication d'un précurseur d'une plaque d'impression lithographique, comprenant les étapes consistant à:
- mettre à disposition un support aluminium,
- grainer et anodiser le support aluminium,
- sans appliquer une couche hydrophile sur le support aluminium anodisé, revêtir le support aluminium grainé et anodisé d'une composition qui est photopolymérisable lors de l'absorption de lumière ayant une longueur d'onde comprise entre 350 nm et 450 nm et qui contient un monomère ou oligomère polymérisable, un liant et un photo-initiateur, afin de forme une couche photopolymérisable,
- revêtir la couche photopolymérisable d'une couche superficielle,
**caractérisé en ce que** le rapport de la quantité de substances solides total de monomère et oligomère polymérisable à la quantité de substances solides total de liant est compris entre 1,55 et 1,95.

2. Procédé pour la fabrication d'un précurseur d'une plaque d'impression lithographique selon la revendication 1, **caractérisé en ce que** la quantité de substances solides total de liant est inférieure à 40% en poids par rapport au poids de substances solides total de la composition.

3. Procédé pour la fabrication d'un précurseur d'une plaque d'impression lithographique selon l'une quelconque des revendications 1 à 2, **caractérisé en ce que** le photo-initiateur est un composé d'hexaarylbisimidazole.

4. Procédé pour la fabrication d'un précurseur d'une plaque d'impression lithographique selon l'une quelconque des revendications 1 à 3, **caractérisé en ce que** la composition contient en outre un mélange de sensibilisateurs répondant à la Formule I, 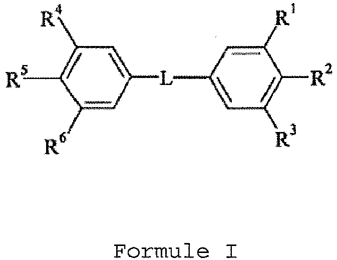 où
R¹ à R⁶ représentent, indépendamment l'un de l'autre, un atome d'hydrogène, un groupe alkyle éventuellement substitué, un groupe alcoxy éventuellement substitué, un groupe cyano, un atome d'halogène, un groupe dialkylamino, un groupe alkylarylamino ou un groupe diarylamino,
L représente un groupe de liaison divalent choisi parmi la liste composée de: 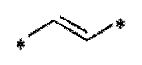 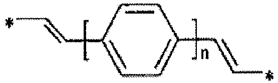 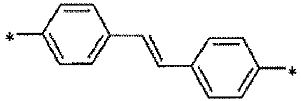 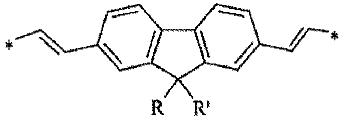 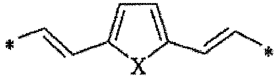 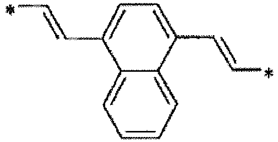
où
n représente un nombre entier de 0 à 2,
X représente S, O ou NR^{x},
* représente les positions de liaison du groupe de liaison L aux groupes phényle de la Formule I,
R, R' et R^{x} représentent un groupe alkyle éventuellement substitué.

5. Procédé pour la fabrication d'une plaque d'impression lithographique, comprenant les étapes consistant à:
- mettre à disposition un précurseur d'une plaque d'impression confectionnée selon l'une quelconque des revendications 1 à 4,
- exposer le précurseur en utilisant un laser ayant une longueur d'onde comprise entre 350 et 450 nm,
- traiter le précurseur exposé dans un révélateur.

6. Procédé selon la revendication 5, **caractérisé en ce qu'**il est effectué une étape de préchauffage avant l'exposition du précurseur et après le développement du précurseur.

7. Procédé selon les revendications 5 ou 6, **caractérisé en ce que** le révélateur est une solution aqueuse ayant un pH compris entre 9,0 et 14,0.

8. Procédé selon la revendication 7, **caractérisé en ce que** la solution aqueuse contient un agent tensioactif répondant à la Formule (V):
R^{a}-R^{b} Formule V
où
R^{a} représente un groupe aryle hydrophobe contenant, outre R^{b}, au moins deux substituants qui ne sont pas un atome d'hydrogène,
R^{b} représente un groupe hydrophile contenant un groupe polyéthylèneoxy comprenant au moins 6 unités d'éthylèneoxy.

9. Procédé selon la revendication 7 ou 8, **caractérisé en ce que** la solution aqueuse contient un agent tensioactif répondant à la Formule (Va): 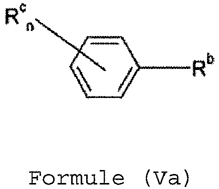 où
R^{b} a la même signification que dans la Formule V,
R^{c} représente un groupe 1,1-phényléthyle ou un groupe t-butyle, en particulier un groupe 1,1-phényléthyle, et
n représente 2 ou 3, en particulier 3.

10. Procédé selon l'une quelconque des revendications 5 à 9, **caractérisé en ce que** la densité d'énergie d'exposition du laser, telle que mesurée sur la surface de la plaque, est inférieure ou égale à 150 *µ*J/cm².
